# DEMANDE DE BREVET EUROPEEN

(11) **EP 4 086 947 A1**
(43) Date de publication de la demande: **09.11.2022**
(21) Numéro de dépôt: 22170064.4
(22) Date de dépôt: 26.04.2022
(51) Int. Cl.: H01L 21/8252, H01L 27/06, H01L 27/085, H01L 29/20, H01L 29/417, H01L 29/778

(54) **DISPOSITIF ELECTRONIQUE POURVU D'UN EMPILEMENT DE DEUX TRANSISTORS A HAUTE MOBILITE ELECTRONIQUE AGENCES EN DEMI-BRAS DE PONT**

(30) Priorité: 05.05.2021 FR 2104752
(71) Demandeur: Exagan, 38040 Grenoble Cedex 9 (FR); STMicroelectronics International N.V., 1228 Plan-les-Ouates, Geneva (CH)
(72) Inventeur: NONGAILLARD, Matthieu, 38000 GRENOBLE (FR); OHEIX, Thomas, 38100 GRENOBLE (FR)
(74) Mandataire: Cabinet Beaumont

(57) **Abrégé**

L'invention concerne un dispositif électronique (100) comprenant, empilés d'une première face (100a) vers une deuxième face (100b), un premier empilement et un deuxième empilement de deux transistors à haute mobilité électronique, dits premier (200) et deuxième (300) transistor, le premier et le deuxième empilement
comprenant chacun, à partir d'une couche isolante (400), intercalée entre le premier et le deuxième empilement, une couche barrière (201, 301) et une couche canal (202, 302), le premier (200) et le deuxième (300) transistor comprenant, respectivement, un premier et un deuxième jeu d'électrodes, le premier et le deuxième jeu d'électrodes étant pourvus chacun d'une électrode de source (204, 304), d'une électrode de drain (205, 305) et d'une électrode de grille (206, 306) qui sont agencées de sorte que le premier (200) et le deuxième (300) transistor forment un demi-bras de pont.

## Description

### DOMAINE DE L'INVENTION

L'invention se rapporte au domaine de l'électronique, et notamment de l'électronique de puissance. Plus particulièrement, la présente invention concerne un dispositif électronique pourvu de deux transistors à haute mobilité électronique.

Le dispositif selon la présente invention est notamment agencé pour permettre une meilleure intégration des deux transistors à haute mobilité électronique.

L'agencement prévu dans la présente invention permet à cet égard l'obtention d'un dispositif compact et permettant de former un demi-bras de pont.

### ARRIERE PLAN TECHNOLOGIQUE DE L'INVENTION

Les transistors à haute mobilité électronique (« HEMT » ou « High Electron Mobility Transistor » selon la terminologie Anglo-Saxonne), bien connus de l'homme du métier, sont aujourd'hui largement mis en œuvre dans le domaine des hyperfréquences et celui des commutateurs pour les convertisseurs en électronique de puissance.

A cet égard, ces transistors HEMT sont généralement élaborés à partir de couches de matériaux semi-conducteurs III-V et plus particulièrement des matériaux semi-conducteurs III-N.

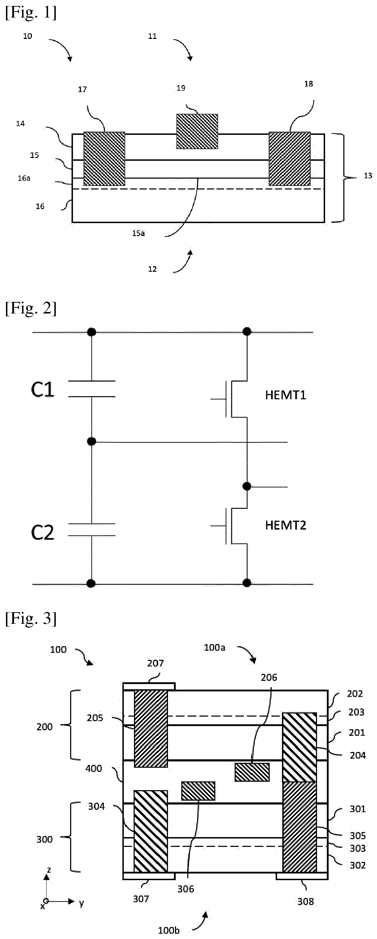

Notamment, la figure 1 représente un transistor HEMT 10 connu de l'état de la technique. Ce transistor HEMT 10 est pourvu d'un empilement 13 qui comprend, d'une face avant 11 vers une face arrière 12, une couche d'isolant 14, une couche barrière 15 et une couche canal 16 apte à former une couche de conduction 16a sous forme d'une couche de gaz électronique à deux dimensions. En particulier, la couche de conduction 16a s'étend dans la couche canal 16 à partir d'une interface 15a, formée entre la couche barrière 15 et ladite couche canal 16.

Les matériaux semi-conducteurs III-V choisis pour former la couche barrière 15 et/ou la couche canal 16 peuvent comprendre du nitrure de gallium (GaN), du nitrure d'aluminium (AlN), des alliages ternaires AlxGa1-xNx, de l'arséniure de gallium (GaAs), des alliages de ternaires d'AlGaAs ou d'InGaAs. Par exemple, la couche barrière 15 et la couche canal 16 peuvent comprendre, respectivement, un composé d'AlGaN et du GaN. La couche d'isolant 14 peut comprendre un matériau diélectrique et notamment du dioxyde de silicium (SiO2) ou nitrure de silicium (Si3N4).

Le transistor HEMT 10 comprend également une électrode de source 17 et une électrode de drain 18 en contact électrique avec la couche de conduction 16a. Plus particulièrement, l'électrode de source 17 et l'électrode de drain 18 débouchent par la face avant 11, et traversent la couche d'isolant 14 et la couche barrière 15 afin d'atteindre l'interface 15a et contacter électriquement la couche de conduction 16a. L'électrode de source 17 et de l'électrode de drain 18 peuvent traverser partiellement ou intégralement la couche de conduction 16a. L'électrode de source 17 et l'électrode de drain 18 peuvent comprendre une espèce métallique, par exemple de l'aluminium, remplissant des tranchées formées dans l'empilement 13.

Le transistor HEMT 10 comprend également une électrode de grille 19 destinée à se voir imposer une tension Vg permettant de contrôler l'état de la couche de conduction 16a. Notamment, dès lors que la différence de potentiel électrique entre l'électrode de grille 19 et l'électrode de source 17, notée Vg-Vs, est supérieure à une tension de seuil Vth caractéristique du transistor HEMT 10, ledit transistor est dans l'état passant. A contrario, dès lors que Vg-Vs est inférieure à Vth, le transistor HEMT 10 est dans l'état non-passant, et se comporte donc comme un interrupteur ouvert.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Ces transistors HEMT peuvent avantageusement être mis en œuvre dans le domaine de la conversion d'énergie, et notamment pour former des demi-bras de pont. Cette architecture, telle que représentée à la figure 2, comprend deux transistors, HEMT1 et HEMT2, montés en série. Dans cet exemple qui présente un montage utilisé dans la conversion d'énergie, celui-ci est associé d'une part à un pont capacitif formé des capacités C1 et C2, et d'autre part à un élément magnétique.

Un tel agencement permet d'optimiser l'exploitation de l'élément magnétique.

Il est toutefois souhaitable de pouvoir mettre en œuvre des transistors HEMT, agencés en demi-bras de pont et de manière dense.

Une solution consistant à réduire la taille des transistors HEMT aura un impact négatif sur leur résistivité Ron à l'état passant, et n'est donc pas souhaitable.

Un but de la présente invention est donc de proposer un agencement compact de deux transistors HEMT formant un demi-bras de pont.

### BREVE DESCRIPTION DE L'INVENTION

Le but de l'invention est atteint par un dispositif électronique comprenant, empilés d'une première face vers une deuxième face, un premier empilement et un deuxième empilement de deux transistors à haute mobilité électronique, dits premier et deuxième transistor, le premier et le deuxième empilement comprenant chacun, à partir d'une couche isolante, intercalée entre le premier et le deuxième empilement, une couche barrière et une couche canal, le premier et le deuxième transistor comprenant, respectivement, un premier et un deuxième jeu d'électrodes, le premier et le deuxième jeu d'électrodes étant pourvus chacun d'une électrode de source, d'une électrode de drain et d'une électrode de grille qui sont agencées de sorte que le premier et le deuxième transistor forment un demi-bras de pont.

Selon un mode de mise en œuvre, l'électrode de source du premier transistor, dite première électrode de source, et l'électrode de drain du deuxième transistor, dite deuxième électrode de drain, sont connectées entre elles.

Selon un mode de mise en œuvre, la première électrode de source et la deuxième électrode de drain forment une unique électrode, dite électrode intermédiaire et qui s'étend du premier empilement vers le deuxième empilement.

Selon un mode de mise en œuvre, l'électrode intermédiaire débouche, par l'une de ses extrémités dite extrémité intermédiaire, en affleurement de l'une ou l'autre de la première et de la deuxième face.

Selon un mode de mise en œuvre, un plot intermédiaire est disposé sur l'une de la première face ou de la deuxième face et dans le prolongement de l'électrode intermédiaire par son extrémité intermédiaire, le plot intermédiaire comprenant avantageusement un matériau semi-conducteur dopé.

Selon un mode de mise en œuvre, l'électrode de drain du premier transistor, dite première électrode de drain, s'étend dans la couche d'isolant et jusque dans la couche canal dudit premier empilement, et l'électrode source du deuxième transistor, dite deuxième électrode de source, s'étend dans la couche d'isolant et jusque dans la couche canal dudit deuxième empilement.

Selon un mode de mise en œuvre, ledit dispositif électronique comprend un plot drain et un plot source disposés, respectivement, sur la première face et la deuxième face, et contactant, respectivement, la première électrode de drain et la deuxième électrode de source, le plot drain et le plot source comprenant avantageusement un matériau semi-conducteur dopé.

Selon un mode de mise en œuvre, les couches canal de l'un et l'autre du premier et du deuxième transistor sont chacune aptes à former une couche de conduction sous forme d'un gaz d'électron à deux dimensions.

Selon un mode de mise en œuvre, les électrodes de grille de l'un et l'autre du premier et du deuxième transistor, dites respectivement première électrode de grille et deuxième électrode de grille, sont configurées pour imposer de manière indépendante, respectivement, au premier transistor et au deuxième transistor, le passage de l'un des états passant et non passant vers l'autre de ces deux états.

Selon un mode de mise en œuvre, ledit dispositif comprend également un premier plot grille et un deuxième plot grille disposés, respectivement, sur la première face et la deuxième face, le premier plot grille étant configuré pour contacter électriquement la première électrode de grille et le deuxième plot grille étant configuré pour contacter électriquement la deuxième électrode de grille, le premier plot grille et le deuxième plot grille comprenant avantageusement un matériau semi-conducteur dopé.

Selon un mode de mise en œuvre, la couche isolante comprend un matériau diélectrique, avantageusement, du dioxyde de silicium ou du nitrure de silicium.

Selon un mode de mise en œuvre, le premier empilement et le deuxième empilement sont essentiellement identiques.

Selon un mode de mise en œuvre, le premier et le deuxième transistor présentent une tension de seuil identique.

Selon un mode de mise en œuvre, les deux couches canal comprennent du GaN et les couches barrière comprennent un alliage ternaire d'AlGaN.

### BREVE DESCRIPTION DES DESSINS

D'autres caractéristiques et avantages de l'invention ressortiront de la description détaillée qui va suivre en référence aux figures annexées sur lesquelles :
la figure 1 est une représentation schématique d'un transistor HEMT connu de l'état de la technique, notamment, le transistor HEMT est représenté selon un plan de coupe perpendiculaire à la face avant ;
la figure 2 est une représentation fonctionnelle d'un montage en demi-bras de pont impliquant la mise en œuvre de deux transistors ;
la figure 3 est une représentation schématique d'un dispositif électronique, selon un plan de coupe passant par la zone active dudit dispositif, conforme à la présente invention ;
la figure 4 est une représentation illustrant le positionnement déporté du premier et du deuxième plot grille permettant de connecter électriquement la première et la deuxième électrode de grille du dispositif électronique de la figure 3 ;
la figure 5 est une représentation illustrant le positionnement déporté du premier plot grille permettant de connecter électriquement la première électrode de grille du dispositif électronique de la figure 3 selon une vue par la première face dudit dispositif ;
la figure 6 est une représentation schématique de la partie primaire d'un circuit de conversion et qui comprend le dispositif électronique selon les termes de la présente invention ;
la figure 7 est une représentation schématique d'un circuit de contrôle mettant en œuvre deux dispositifs électroniques selon les termes de la présente invention.

### DESCRIPTION DETAILLEE DE L'INVENTION

Il est entendu que les différentes figures présentées en relation avec la présente description ne sont données qu'à titre d'illustration et ne limitent en aucune manière l'invention. Il est notamment clair que les échelles ou dimensions relatives peuvent ne pas être respectées.

Dans toute la description, il est admis qu'une couche ou une interface est généralement plane et s'étend selon un plan parallèle au plan (0, x, y) du repère orthonormé (0, x, y, z). Par ailleurs, dès lors qu'il est fait référence à une représentation selon un plan de coupe, ce dernier est perpendiculaire à l'ensemble des plans formés par les couches, et plus particulièrement perpendiculaire au plan (0, x, y). Il est également entendu que, dès lors qu'il est fait référence à un empilement de couches, ces dernières sont empilées selon la direction z du repère orthonormé (0, x, y, z).

La présente invention concerne un dispositif électronique pourvu de deux transistors à haute mobilité électronique (ci-après « transistor HEMT ») dits, respectivement, premier transistor et deuxième transistor, et agencés en demi-bras de pont.

En particulier, le dispositif électronique comprend, d'une première face vers une deuxième face, un premier empilement et un deuxième empilement formant respectivement le premier et le deuxième transistor.

A cet égard, le premier et le deuxième empilement comprennent chacun, à partir d'une couche isolante, intercalée entre le premier et le deuxième empilement, une couche barrière et une couche canal. Une couche canal d'un transistor HEMT est notamment apte, lorsque ledit transistor HEMT est dans un état passant, à former une couche de conduction sous forme d'un gaz d'électron bidimensionnel (« 2DEG »).

Le premier et le deuxième transistor comprennent, respectivement, un premier et un deuxième jeu d'électrodes. Le premier et le deuxième jeu d'électrodes sont chacun pourvus d'une électrode de source, d'une électrode de drain et d'une électrode de grille qui sont agencées de sorte que le premier et le deuxième transistor forment un demi-bras de pont.

Pour un transistor HEMT donné, le passage de l'un ou l'autre de l'état passant et de l'état non passant vers l'autre de ces deux états est contrôlé par l'électrode de grille du transistor concerné. Plus particulièrement, ce contrôle est exécuté en imposant une tension Vg à l'électrode de grille. Notamment, dès lors que la différence de potentiel Vg-Vs entre l'électrode de grille et l'électrode de source du transistor HEMT est supérieure à sa tension de seuil Vth, ledit transistor est dans l'état passant et se comporte comme un fil conducteur. A contrario, dès lors que la différence de potentiel Vg-Vs est inférieure à la tension de seuil, le transistor HEMT est dans un état non passant et se comporte comme un interrupteur ouvert.

Un demi-bras de pont selon les termes de la présente invention est un agencement de deux transistors HEMT connectés en série. Notamment, l'électrode de source du premier transistor, dite première électrode de source, est électriquement connectée avec l'électrode de drain du deuxième transistor, dite deuxième électrode de drain. L'agencement comprend également trois ports de connexions dits port drain, port source et port intermédiaire. Le port drain permet notamment de connecter l'électrode de drain du premier transistor, le port source permet de connecter l'électrode de source du deuxième transistor et enfin le port intermédiaire permet de connecter la deuxième électrode de drain et la première électrode de source.

La figure 3 représente de manière schématique un dispositif électronique 100 selon les termes de la présente invention.

Le dispositif 100 comprend notamment deux transistors à haute mobilité électroniques (« Transistor HEMT ») dits, respectivement, premier transistor 200 et deuxième transistor 300. En particulier, le dispositif 100 comprend d'une première face 100a vers une deuxième face 100b, le premier transistor 200, une couche isolante 400 et le deuxième transistor 300.

La couche isolante 400 peut comprendre un matériau diélectrique, avantageusement, du dioxyde de silicium ou du nitrure de silicium

Le premier transistor 200 et le deuxième transistor 300 comprennent chacun un empilement de couches semi-conductrices dits, respectivement, premier empilement et deuxième empilement.

Chaque empilement de couches semi-conductrices peut notamment comprendre des matériaux semi-conducteurs du groupe III-V, et plus particulièrement des matériaux semi-conducteurs du groupe III-N. Les matériaux semi-conducteurs du groupe III-V pourront notamment être choisis parmi le nitrure de gallium (GaN), le nitrure d'aluminium (AlN) et leurs alliages ternaires AlxGa1-xN, ou parmi l'arséniure de gallium (GaAs) et ses composés (AlGaAs, InGaAs).

Chaque empilement de couches semi-conductrices comprend, depuis la couche isolante, une couche barrière et une couche canal.

Notamment, le premier empilement comprend, depuis la couche isolante 400 et vers la première face 100a, une première couche barrière 201 et une première couche canal 202.

De manière équivalente, le deuxième empilement comprend, depuis la couche isolante 400 et vers la deuxième face 100b, une deuxième couche barrière 301 et une deuxième couche canal 302.

A titre d'exemple, et selon la présente invention, une couche barrière peut comprendre un alliage ternaire d'AlxGa1-xN, tandis qu'une couche canal peut comprendre du GaN.

Par ailleurs, une couche barrière peut présenter une épaisseur comprise entre 1 nm et 100 nm.

Une couche canal peut présenter une épaisseur comprise entre 10 nm et 2µm.

Le premier et le deuxième empilement peuvent être essentiellement identiques.

Un empilement de couches semi-conductrices, selon les termes de la présente invention, est apte à former une couche de gaz d'électrons à deux dimensions (2DEG pour « 2-dimensional electron gaz ») qui constitue une couche de conduction.

La couche de conduction, au sein d'un empilement de couches semi-conductrices, s'étend dans la couche canal, à partir de l'interface formée entre la couche barrière et la couche canal de l'empilement considéré. La couche de conduction est notamment susceptible d'être formée au sein d'un transistor HEMT dès lors que ce dernier se trouve dans un état passant.

Ainsi, dès lors que le premier transistor 200 est dans l'état passant, la première couche canal 202 est apte à former une première couche de conduction 203 qui s'étend dans ladite première couche canal 202, à partir d'une première interface formée entre la première couche barrière 201 et la première couche canal 202.

De manière équivalente, dès lors que le deuxième transistor 300 est dans l'état passant, la deuxième couche canal 302 est apte à former une deuxième couche de conduction 303 qui s'étend dans ladite deuxième couche canal 202, à partir d'une deuxième interface formée entre la deuxième couche barrière 301 et la deuxième couche canal 302.

Chaque transistor HEMT comprend un jeu d'électrodes pourvu d'une électrode de source, d'une électrode de drain et d'une électrode de grille.

Plus particulièrement, le premier transistor 200 comprend un des deux jeux d'électrodes dit premier jeu. Le premier jeu est pourvu d'une première électrode de source 204, d'une première électrode de drain 205 et d'une première électrode de grille 206.

De manière équivalente, le deuxième transistor 300 comprend l'autre des deux jeux d'électrodes, dit deuxième jeu. Le deuxième jeu est pourvu d'une deuxième électrode de source 304, d'une deuxième électrode de drain 305 et d'une deuxième électrode de grille 306.

La première électrode de source 204 et la première électrode de drain 205 s'étendent de la couche isolante 400 vers le premier empilement. Plus particulièrement, la première électrode de drain 205 et la première électrode de source 204 traversent pour partie le premier empilement et notamment la première couche canal 202. Ainsi, l'une et l'autre de la première électrode de drain 205 et de la première électrode de source 204 contactent électriquement la première couche canal 202 et plus particulièrement la première couche de conduction 203.

Par surcroit, la première électrode de drain 205 débouche par la première face 100a. à cet égard, le dispositif peut comprendre un plot, dit plot drain 207, reposant sur la première face 100a et au contact de la première électrode de drain 205. Ce plot drain 207 forme un premier terminal (ou premier port) du dispositif 100. Le plot drain 207 comprend avantageusement un matériau semi-conducteur dopé, par exemple du silicium dopé.

La deuxième électrode de source 304 et la deuxième électrode de drain 305 s'étendent de la couche isolante 400 vers le deuxième empilement. Plus particulièrement, la deuxième électrode de drain 305 et la deuxième électrode de source 304 traversent pour partie le deuxième empilement et notamment la deuxième couche canal 302. Ainsi, l'une et l'autre de la deuxième électrode de drain 305 et de la deuxième électrode de source 304 contactent électriquement la deuxième couche canal 302 et plus particulièrement la deuxième couche de conduction 303.

Par surcroit, la deuxième électrode de source 304 débouche par la deuxième face 100b. à cet égard, le dispositif peut comprendre un autre plot, dit plot source 307, reposant sur la deuxième face et au contact de la deuxième électrode de drain. Ce plot source 307 forme un deuxième terminal (ou deuxième port) du dispositif électronique 100. Le plot source 307 comprend avantageusement un matériau semi-conducteur dopé, par exemple du silicium dopé.

Enfin, la première électrode de source 204 et la deuxième électrode de drain 305 sont électriquement connectées entre elles. Plus particulièrement, la première électrode de source 204 et la deuxième électrode de drain 305 forment une unique électrode, dite électrode intermédiaire, qui s'étend du premier empilement vers le deuxième empilement.

En particulier, l'électrode intermédiaire peut déboucher par une de ses extrémités, dite extrémité intermédiaire, selon l'une ou l'autre de la première face 100a et de la deuxième face 100b. L'électrode intermédiaire représentée sur la figure 3 débouche selon une de ses extrémités par la deuxième face 100b.

Le dispositif électronique 100 peut également comprendre dans le prolongement de l'électrode intermédiaire par son extrémité intermédiaire, un plot intermédiaire 308. Le plot intermédiaire 308, qui forme un terminal intermédiaire (ou port intermédiaire), est notamment disposé sur l'une ou l'autre de la première face et de la deuxième face. Le plot intermédiaire 308, à l'instar du plot source et du plot drain, peut comprendre un semi-conducteur dopé, par exemple du silicium dopé.

La première électrode de grille 206 et la deuxième électrode de grille 306, sont configurées pour imposer de manière indépendante, respectivement, au premier transistor et au deuxième transistor, le passage de l'un des états passant et non passant vers l'autre de ces deux états.

Ainsi, la première électrode de grille 206 est agencée pour piloter ou contrôler l'état du premier transistor 200. Notamment, ce contrôle est exécuté en imposant un potentiel électrique Vg à la première électrode de grille 206, et plus particulièrement une différence de potentiel électrique DDP, noté Vg-Vs entre la première électrode de grille 206 et la première électrode de source 204.

Ainsi, dès lors que Vg-Vs, est supérieure à une tension de seuil Vth caractéristique du transistor 200, ce dernier est dans l'état passant et se comporte comme un fil conducteur. A contrario, dès lors que Vg-Vs est inférieure à Vth, le transistor 200 est dans l'état non-passant, et se comporte donc comme un interrupteur ouvert.

De manière équivalente, la deuxième électrode de grille 306 est agencée pour piloter ou contrôler l'état du deuxième transistor 300. Notamment, ce contrôle est exécuté en imposant un potentiel électrique Vg à la deuxième électrode de grille 306, et plus particulièrement une différence de potentiel électrique DDP, noté Vg-Vs entre la deuxième électrode de grille 306 et la deuxième électrode de source 307.

Ainsi, dès lors que Vg-Vs, est supérieure à une tension de seuil Vth caractéristique du transistor 300, ce dernier est dans l'état passant et se comporte comme un fil conducteur. A contrario, dès lors que Vg-Vs est inférieure à Vth, le transistor 300 est dans l'état non-passant, et se comporte donc comme un interrupteur ouvert.

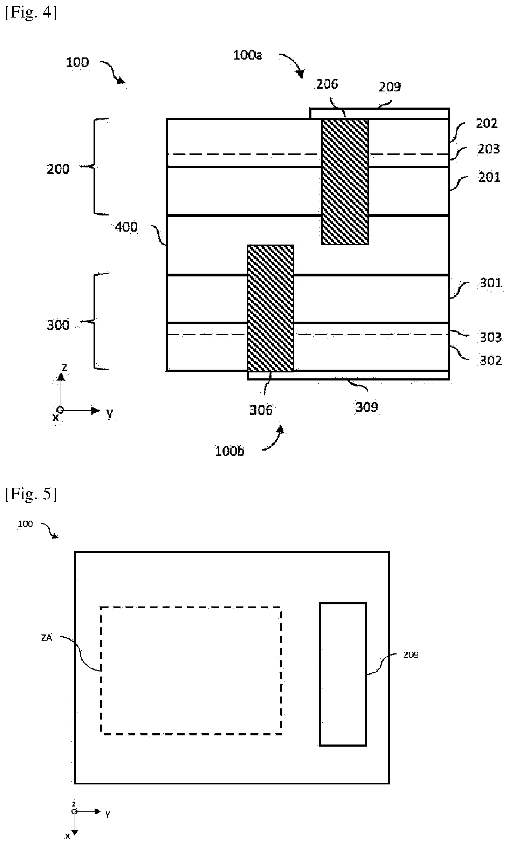

Le dispositif électrique 100 peut comprendre deux plots, dits premier plot grille 209 et deuxième plot grille 309, disposés, respectivement, sur la première face 100a et la deuxième face 100b. En particulier, le premier plot grille 209 et le deuxième plot grille 309 permettent de contacter électriquement, respectivement, la première électrode de grille 206 et la deuxième électrode de grille 306 (figure 4). Notamment, les deux plots grille 209 et 309 sont déportés des deux zones actives ZA des transistors HEMT 200 et 300 de manière à ne pas risquer de contacter électriquement la première couche de conduction 203 et la deuxième couche de conduction 303. Par « déporté », on entend un plot grille qui est disposé en dehors d'un contour délimitant l'une et l'autre des zones actives ZA du premier et du deuxième transistor. A cet égard, la figure 5 est une représentation du dispositif 100 selon une vue par la première face (selon un plan parallèle au plan (0, x, y)). Les pointillés délimitent une section active ZA du dispositif électronique au sein de laquelle tout contact entre la première et la deuxième électrode de grille et l'une et l'autre des couches barrière et canal est évité. Le premier plot grille et le deuxième plot grille peuvent avantageusement comprendre un matériau semi-conducteur dopé.

De manière avantageuse, le premier empilement et le deuxième empilement sont essentiellement identiques.

Toujours de manière avantageuse, le premier et le deuxième transistor présentent une tension de seuil identique.

Dans l'architecture proposée dans la présente invention, l'état passant ou non passant de l'un et l'autre du premier et du deuxième transistor est contrôlé de manière indépendante.

Notamment, il est possible d'imposer un état passant au premier transistor et un état non passant au deuxième transistor. Selon cette configuration, un courant peut circuler dans le dispositif électronique du premier terminal vers le terminal intermédiaire.

De manière équivalente, il est possible d'imposer un état non passant au premier transistor et un état passant au deuxième transistor. Selon cette configuration, un courant peut circuler dans le dispositif électronique du terminal intermédiaire vers le deuxième terminal.

Ce mode de fonctionnement peut avantageusement être mis à profit dans un circuit de conversion 1000.

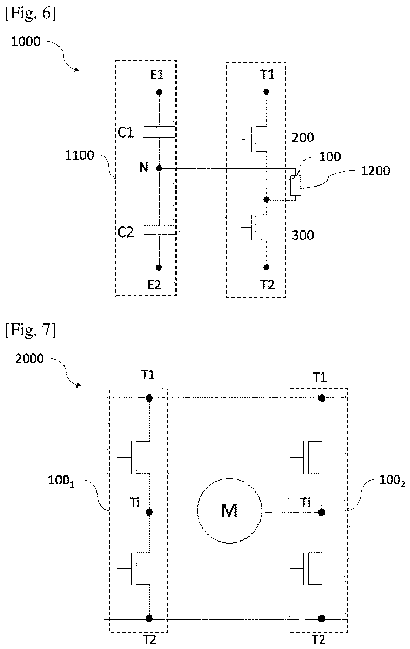

A cet égard, la figure 6 représente la partie primaire d'un circuit de conversion 1000 et qui comprend le dispositif électronique 100.

En particulier, le circuit de conversion 1000 comprend une première branche 1100, une deuxième branche formée par le dispositif électronique 100, ainsi qu'un élément magnétique 1200, par exemple une bobine primaire magnétique.

La première branche 1100 comprend notamment, d'une première extrémité E1 vers une deuxième extrémité E2, un premier composant C1 et un deuxième composant C2 connectés en série et présentent une borne commune N. Le premier composant C1 et le deuxième composant C2 peuvent notamment comprendre une diode ou une capacité.

La première extrémité E1 et la deuxième extrémité E2 sont connectées, respectivement, avec le premier terminal T1 et le deuxième terminal T2 du dispositif électronique 100.

L'élément magnétique 1200 comprend deux extrémités connectées, respectivement au nœud N et au terminal intermédiaire.

Cet agencement de la partie primaire d'un circuit de conversion 1000 avec deux transistors HEMT connectés en demi-bras de pont permet de mettre en œuvre un unique élément magnétique. En effet, chaque transistor HEMT coopère avec cette dernière selon un rapport cyclique de 0,5, de sorte que ledit élément magnétique est mis en œuvre sans interruption.

Ce circuit de conversion 1000 reste compact.

Le dispositif électronique 100 peut également être mis en œuvre pour la formation d'un circuit de contrôle 2000 d'un moteur M (illustré à la figure 7).

Notamment, le circuit de contrôle 2000 comprend notamment deux dispositifs électroniques 1001 et 1002 selon les termes de la présente invention connecté en parallèle. En particulier, les premiers terminaux T1 d'une part et les deuxièmes terminaux T2 d'autre part des dispositifs électroniques 1001 et 1002 sont connectés entre eux.

Les deux terminaux intermédiaires Ti forment alors des bornes auxquelles un moteur M peut être connecté.

De manière générale, l'agencement selon la présente invention de deux transistors HEMT, sous forme d'un empilement, permet de conserver une compacité appréciable sans pour autant affecter la résistance Ron à l'état passant des transistors HEMT considérés.

Bien sûr, l'invention n'est pas limitée aux modes de réalisation décrits et on peut y apporter des variantes de réalisation sans sortir du cadre de l'invention tel que défini par les revendications.

## Revendications

1. Dispositif électronique (100) comprenant, empilés d'une première face (100a) vers une deuxième face (100b), un premier empilement et un deuxième empilement de deux transistors à haute mobilité électronique, dits premier (200) et deuxième (300) transistor, le premier et le deuxième empilement comprenant chacun, à partir d'une couche isolante (400), intercalée entre le premier et le deuxième empilement, une couche barrière (201, 301) et une couche canal (202, 302), le premier (200) et le deuxième (300) transistor comprenant, respectivement, un premier et un deuxième jeu d'électrodes, le premier et le deuxième jeu d'électrodes étant pourvus chacun d'une électrode de source (204, 304), d'une électrode de drain (205, 305) et d'une électrode de grille (206, 306) qui sont agencées de sorte que le premier (200) et le deuxième (300) transistor forment un demi-bras de pont.

2. Dispositif électronique (100) selon la revendication 1, dans lequel l'électrode de source du premier transistor (200), dite première électrode de source (204), et l'électrode de drain du deuxième transistor (300), dite deuxième électrode de drain (305), sont connectées entre elles.

3. Dispositif électronique (100) selon la revendication 2, dans lequel la première électrode de source (204) et la deuxième électrode de drain (305) forment une unique électrode, dite électrode intermédiaire et qui s'étend du premier empilement vers le deuxième empilement.

4. Dispositif électronique (100) selon la revendication 3, dans lequel l'électrode intermédiaire débouche, par l'une de ses extrémités dite extrémité intermédiaire, en affleurement de l'une ou l'autre de la première et de la deuxième face (100a, 100b) .

5. Dispositif électronique (100) selon la revendication 4, dans lequel un plot intermédiaire est disposé sur l'une de la première face (100a) ou de la deuxième face (100b) et dans le prolongement de l'électrode intermédiaire par son extrémité intermédiaire, le plot intermédiaire (308) comprenant avantageusement un matériau semi-conducteur dopé.

6. Dispositif électronique (100) selon l'une des revendications 1 à 5, dans lequel l'électrode de drain du premier transistor (200), dite première électrode de drain (205), s'étend dans la couche d'isolant (400) et jusque dans la couche canal (202) dudit premier empilement, et dans lequel l'électrode de source du deuxième transistor (300), dite deuxième électrode de source (304), s'étend dans la couche d'isolant (400) et jusque dans la couche canal (302) dudit deuxième empilement.

7. Dispositif électronique (100) selon la revendication 6, dans lequel ledit dispositif électronique (100) comprend un plot drain (207) et un plot source (307) disposés, respectivement, sur la première face (100a) et la deuxième face (100b), et contactant, respectivement, la première électrode de drain (205) et la deuxième électrode de source (304), le plot drain (207) et le plot source (307) comprenant avantageusement un matériau semi-conducteur dopé.

8. Dispositif électronique (100) selon l'une des revendications 1 à 7, dans lequel les couches canal (202, 302) de l'un et l'autre du premier et du deuxième transistor sont chacune aptes à former une couche de conduction (203, 303) sous forme d'un gaz d'électron à deux dimensions.

9. Dispositif électronique (100) selon l'une des revendications 1 à 8, dans lequel les électrodes de grille (206, 306) de l'un et l'autre du premier et du deuxième transistor, dites respectivement première électrode de grille (206) et deuxième électrode de grille (306), sont configurées pour imposer de manière indépendante, respectivement, au premier transistor (200) et au deuxième transistor (300), le passage de l'un des états passant et non passant vers l'autre de ces deux états.

10. Dispositif électronique (100) selon la revendication 9, dans lequel ledit dispositif comprend également un premier plot grille (209) et un deuxième plot grille (309) disposés, respectivement, sur la première face (100a) et la deuxième face (100b), le premier plot grille (209) étant configuré pour contacter électriquement la première électrode de grille (206) et le deuxième plot grille (309) étant configuré pour contacter électriquement la deuxième électrode de grille (306), le premier plot grille (209) et le deuxième plot grille (309) comprenant avantageusement un matériau semi-conducteur dopé.

11. Dispositif électronique (100) selon l'une des revendications 1 à 10, dans lequel la couche isolante (400) comprend un matériau diélectrique, avantageusement, du dioxyde de silicium ou du nitrure de silicium.

12. Dispositif électronique (100) selon l'une des revendications 1 à 11, dans lequel le premier empilement et le deuxième empilement sont essentiellement identiques.

13. Dispositif électronique (100) selon l'une des revendications 1 à 12, dans lequel le premier (200) et le deuxième (300) transistor présentent une tension de seuil identique.

14. Dispositif électronique (100) selon l'une des revendications 1 à 13, dans lequel les deux couches canal (202, 302) comprennent du GaN et les couches barrière (201, 301) comprennent un alliage ternaire d'AlGaN.
